# EUROPEAN PATENT APPLICATION

(11) **EP 1 813 654 A1**
(43) Date of publication of application: **01.08.2007**
(21) Application number: 07001889.0
(22) Date of filing: 29.01.2007
(51) Int. Cl.: C09D 11/00, C09D 11/10, H01B 1/22, H05K 1/09

(54) **Radiation curable conductive ink and manufacturing method for using the same**

(30) Priority: 30.01.2006 JP 2006021116
(71) Applicant: Yang, Yung-Shu, Shihlin District Taipei City 111 (TW)
(72) Inventor: Yang, Yung-Shu, Shihlin District Taipei City 111 (TW)
(74) Representative: Becker Kurig Straus

(57) **Abstract**

The present invention provides a radiation curable conductive ink and a manufacturing method for conductive substrate using the conductive ink, wherein components of the radiation curable conductive ink contain at least conductive powder having a covering layer and a photosensitive binder. The radiation curable conductive ink is printed on surface of a substrate using a screen printing method, and a chemical crosslinking reaction is achieved by irradiating the conductive ink with ultraviolet ray, visible light or electron beam, thereby forming a conductive substrate. The conductive substrate is particularly applicable for use in laminate type electronic devices, including radio frequency identification (RFID) antenna, printed-circuit boards, smart cards (non-contact chip cards) components, smart labels, printed electronics, anti-electromagnetic interference (EMI) and anti-electrostatic materials.

## Description

### BACKGROUND OF THE INVENTION

### (a) Field of the Invention

The present invention relates to a radiation curable conductive ink and manufacturing method for conductive substrate using conductive ink, which is particularly applicable for use in electronic materials, including radio frequency identification (RFID) antenna, printed-circuit boards, smart cards (non-contact chip cards) components, smart labels, printed electronics, anti-electromagnetic interference (EMI) and anti-electrostatic materials.

### (b) Description of the Prior Art

The driving force of technological progress has accentuated multifunctionality and continuous miniaturization in the design of various electronic products. More particularly, rapid development in networking and wireless communication in recent years has seen the perpetual modification in a diverse range of portable electronic products, which has altered the unlimited potentiality of 21 st century modes of business.

There is an inseparable relationship between advancement in the miniaturization of electronic products and electronic materials, for instance, laminate type antenna are replacing traditional stem antenna, and the lamination of printed-circuit boards has made miniature cellular phones available to the market. Moreover, rapid growth in radio frequency Identification (RFID) in recent years has seen the application of RFID in electronic money, animal chip readers, smart cards (non-contact chip cards), smart store shopping, and so on, which have already become an intimate part of the lives of consumers.

Although lamination of the aforementioned laminate type antenna, printed-circuit boards and radio frequency identification systems offer convenience of use, however, the current cost of manufacture is still very high, with the result that many innovative products or new modes of business are still speculative and non-viable.

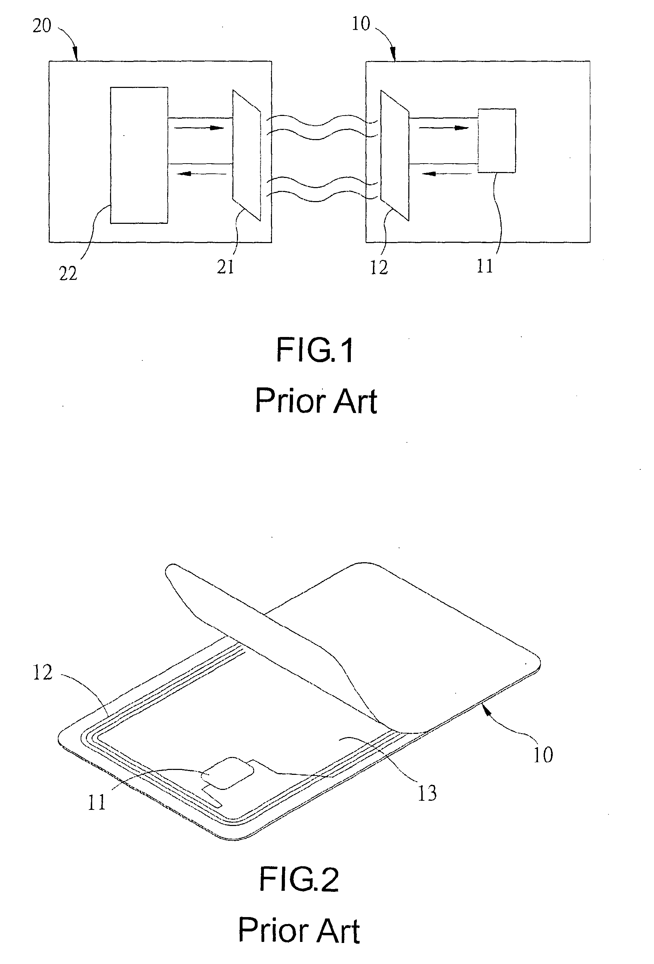

Referring to FIG. 1, which shows an example of the radio frequency identification (RFID) applied in a smart card (non-contact chip card), the principle of which involves the transmission of signals from a chip 11 on a smart card 10 to a reader 20 through a laminated antenna 12. An antenna 21 of the reader 20 then receives the signals, and a microprocessor 22 decodes the signals to form readable information. Furthermore, the reader 20 can also deliver other data to the smart card 10, whereupon the chip 11 on the smart card 10 proceeds with writing operations. Because the transmission method implemented is an inductive type (using a coil resonance producing high frequency signal induction), thus, a power supply does not need to be installed in the smart card 10.

In principle, the aforementioned transmitting terminal of the radio frequency identification can be configured on any type of inexpensive product, and can even altogether replace current bar codes as used on all types of commodities, thus bringing infinite convenience and completely changing current lifestyle trends.

However, current technology is still unable to overcome the problem of the high cost of radio frequency identification systems, primarily because of the high cost of the aforementioned antenna compared, which can cost higher than the chips.

Referring to FIG. 2, which shows the aforementioned antenna 12 of the smart card 10 primarily structured by disposing a wound coil on a laminated substrate 13, thereby forming the antenna 12 that is able to transmit and receive signals. A traditional etching method is used to dispose the wound coil onto the laminated substrate 13. However, even mass production is unable to reduce costs because of complications in the job program.

Hence, working procedure can be effectively reduced and savings on costs made if a screen printing method is used to directly mount the wound coil onto the laminated substrate. Even though current technology has enabled the universal adoption of screen printing in the manufacture of circuit substrate, however, the current primary use of traditional thermal curable conductive ink containing pure silver powder is unable to effectively reduce manufacturing costs when used on the aforementioned radio frequency identification antenna or circuit board.

Accordingly, the inventor of the present invention has developed a radiation curable conductive ink and a manufacturing method for conductive substrate using the conductive ink that effectively reduces manufacturing costs.

### SUMMARY OF THE INVENTION

In an embodiment of radiation curable conductive ink the present invention, a chemical crosslinking reaction is achieved by irradiating the conductive ink with radiation, wherein the radiation used is either ultraviolet ray, visible light ray, electron beam or a combination of more than one of these three different rays. The conductive ink contains at least the following components:
(a) The conductive powder having a covering layer, wherein the weight of the silver content of the conductive powder before covering with the covering layer accounts for less than 90% of the weight of the conductive powder without the covering layer;
(b) The covering layer covering surface of the conductive powder, wherein the weight of silver content of the covering layer accounts for more than 30% of the weight of the covering layer, and the weight of the covering layer accounts for less than 80% of the total weight of the conductive powder and the covering layer;
(c) The conductive powder having the covering layer, wherein average size of the conductive powder is less than 40 micro;
(d) A photosensitive binder having a viscosity less than 5,000 cps under temperature condition at 25°C and contains at least one reactive cyclized organic compound that can undergo polymerization, such as reactive cyclized monomer or reactive cyclized oligomer.

In another embodiment of the radiation curable conductive ink of the present invention, a chemical crosslinking reaction is achieved by irradiating the conductive ink with radiation, wherein the radiation used is either ultraviolet ray, visible light ray, electron beam or a combination of more than one of these three different rays. The conductive ink contains at least the following components:
(a) The conductive powder having a covering layer, wherein the weight of copper content of the conductive powder before covering with the covering layer accounts for more than 30% of the weight of the conductive powder without the covering layer;
(b) The covering layer covering surface of the conductive powder, wherein the weight of silver content of the covering layer accounts for more than 30% of the weight of the covering layer, and the weight of the covering layer accounts for less than 80% of the total weight of the conductive powder and the covering layer;
(c) The conductive powder having the covering layer, wherein average size of the conductive powder is less than 40 micro;
(d) The photosensitive binder having a viscosity less than 5,000 cps under temperature condition at 25°C and contains at least one reactive cyclized organic compound that can undergo polymerization, such as reactive cyclized monomer or reactive cyclized oligomer.

In another embodiment of the radiation curable conductive ink of the present invention, a chemical crosslinking reaction is achieved by irradiating the conductive ink with radiation, wherein the radiation used is either ultraviolet ray, visible light ray, electron beam or a combination of more than one of these three different rays. The conductive ink contains at least the following components:
(a) The conductive powder having a covering layer, wherein the weight of aluminum content of the conductive powder before covering with the covering layer accounts for more than 30% of the weight of the conductive powder without the covering layer;
(b) The covering layer covering surface of the conductive powder, wherein the weight of silver content of the covering layer accounts for more than 30% of the weight of the covering layer, and the weight of the covering layer accounts for less than 80% of the total weight of the conductive powder and the covering layer;
(c) The conductive powder having the covering layer, wherein average size of the conductive powder is less than 40 micro;
(d) The photosensitive binder having a viscosity less than 5,000 cps under temperature condition at 25°C and contains at least one reactive cyclized organic compound that can undergo polymerization, such as reactive cyclized monomer or reactive cyclized oligomer.

In another embodiment of the radiation curable conductive ink of the present invention, a chemical crosslinking reaction is achieved by irradiating the conductive ink with radiation, wherein the radiation used is either ultraviolet ray, visible light ray, electron beam or a combination of more than one of these three different rays. The conductive ink contains at least the following components:
(a) Metallic conductive powder, wherein the average size of the of the conductive powder is less than 40 micro;
(b) A photosensitive binder having a viscosity less than 5,000 cps under temperature condition at 25°C and contains at least one reactive cyclized organic compound that can undergo polymerization, such as reactive cyclized monomer or reactive cyclized oligomer.

A manufacturing method for conductive substrate using screen printing is realized using the aforementioned components of the radiation curable conductive ink of the present invention, thereby foreshortening working procedure and reducing cost, wherein method adopted is disclosed below:

The manufacturing method for conductive substrate comprises the following steps:
(a) Apply the conductive powder, wherein weight of silver content of the conductive powder accounts for less than 90% of the weight of the conductive powder;
(b) Cover the conductive powder with the covering layer, wherein the weight of silver content of the covering layer accounts for more than 30% of the weight of the covering layer, and the weight of the covering layer accounts for less than 80% of the total weight of the conductive powder and the covering layer, and the conductive powder having the covering layer, wherein average size of the conductive powder is less than 40 micro;
(c) Mix the conductive powder having the covering layer and the photosensitive binder, wherein the photosensitive binder has a viscosity of less than 5,000 cps at a temperature of 25°C and contains at least one reactive cyclized organic compound that can undergo polymerization, such as reactive cyclized monomer or reactive cyclized oligomer, thereby forming the radiation curable conductive ink;
(d) Print the radiation curable conductive ink onto a surface of a substrate using a screen printing method;
(e) Expose the radiation curable conductive ink to radiation, wherein the radiation used is either ultraviolet ray, visible light ray, electron beam or a combination of more than one of these three different rays, thereby causing the radiation curable conductive ink to undergo a chemical crosslinking reaction, and the conductive substrate is formed therefrom.

A manufacturing method for conductive substrate using the radiation curable conductive ink comprises the following steps:
(a) Apply the conductive powder, wherein weight of copper content of the conductive powder accounts for more than 30% of the weight of the conductive powder;
(b) Cover the conductive powder with the covering layer, wherein the weight of silver content of the covering layer accounts for more than 30% of the weight of the covering layer, and the weight of the covering layer accounts for less than 80% of the total weight of the conductive powder and the covering layer, and the conductive powder having the covering layer, wherein average size of the conductive powder is less than 40 micro;
(c) Mix the conductive powder having the covering layer and the photosensitive binder, wherein the photosensitive binder has a viscosity of less than 5,000 cps at a temperature of 25°C and at least one reactive cyclized organic compound that can undergo polymerization, such as reactive cyclized monomer or reactive cyclized oligomer, thereby forming the radiation curable conductive ink;
(d) Print the radiation curable conductive ink onto a surface of the substrate using a screen printing method;
(e) Expose the radiation curable conductive ink to radiation, wherein the radiation used is either ultraviolet ray, visible light ray, electron beam or a combination of more than one of these three different rays, thereby causing the radiation curable conductive ink to undergo a chemical crosslinking reaction, and the conductive substrate is formed therefrom.

A manufacturing method for conductive substrate using the radiation curable conductive ink comprises the following steps:
(a) Apply the conductive powder, wherein weight of aluminum content of the conductive powder accounts for more than 30% of the weight of the conductive powder;
(b) Cover the conductive powder with the covering layer, wherein the weight of silver content of the covering layer accounts for more than 30% of the weight of the covering layer, and the weight of the covering layer accounts for less than 80% of the total weight of the conductive powder and the covering layer, and the conductive powder having the covering layer, wherein average size of the conductive powder is less than 40 micro;
(c) Mix the conductive powder having the covering layer and the photosensitive binder, wherein the photosensitive binder has a viscosity of less than 5,000 cps at a temperature of 25°C and contains at least one reactive cyclized organic compound that can undergo polymerization, such as reactive cyclized monomer or reactive cyclized oligomer, thereby forming the radiation curable conductive ink;
(d) Print the radiation curable conductive ink onto a surface of the substrate using a screen printing method;
(e) Expose the radiation curable conductive ink to radiation, wherein the radiation used is either ultraviolet ray, visible light ray, electron beam or a combination of more than one of these three different rays, thereby causing the radiation curable conductive ink to undergo a chemical crosslinking reaction, and the conductive substrate is formed therefrom.

A manufacturing method for conductive substrate using the radiation curable conductive ink comprises the following steps:
(a) Apply the metallic conductive powder, wherein the average size of the of the conductive powder is less than 40 micro;
(b) A photosensitive binder having a viscosity less than 5,000 cps under temperature condition at 25°C and contains at least one reactive cyclized organic compound that can undergo polymerization, such as reactive cyclized monomer or reactive cyclized oligomer;
(c) Mix the conductive powder and the aforementioned photosensitive binder, thereby forming the radiation curable conductive ink;
(d) Print the radiation curable conductive ink onto a surface of the substrate using a screen printing method;
(e) Expose the radiation curable conductive ink to radiation, wherein the radiation used is either ultraviolet ray, visible light ray, electron beam or a combination of more than one of these three different rays, thereby causing the radiation curable conductive ink to undergo a chemical crosslinking reaction, and the conductive substrate is formed therefrom.

A manufacturing method for conductive substrate using screen printing is realized using the aforementioned radiation curable conductive ink of the present invention and the method of using conductive ink to manufacture the conductive substrate, thereby achieving objectives of foreshortening working procedure and reducing cost. The method is particularly applicable for applications in radio frequency identification RFID antenna, printed-circuit boards, smart cards (non-contact chip cards) component members, smart labels, printed electronics, anti-EMI and anti-static materials.

Furthermore, the radiation curable conductive ink mixed with the aforementioned components undergoes a chemical crooslinking reaction that generally occurs within a few seconds compared to between 3 minutes to 2 hours and a temperature around 80°C - 220°C needed by general thermal curable resins (for example: thermal curable type epoxy resin and polyester resin), thereby providing the present invention with advantages of rapid curable and energy savings.

After the conductive powder applied by combining properties of the aforementioned materials has undergone radiation crosslinking, apart from having the advantage of rapid curing speed, moreover, the resulting conductive substrate is provided with superior electrical conductivity and resistance to oxidation.

In addition, because of a light-screening effect and high specific gravity of the conductive powder, rapid sedimentation of the metallic powder easily causes, which makes it difficult for the radiation curable conductive ink to achieve an ideal degree of cure. Moreover, it is difficult for the metallic powder to be uniformly dispersed and achieve a substantially thick conductive ink.

The present invention has made improvements that resolve the aforementioned shortcomings, and enables the radiation curable conductive ink to undergo a rapid and curing reaction that achieves favorable metallic powder dispersibility and superior electrical conductivity, as well as superior electrical conductivity stability, resistance to oxidation and low cost.

To enable a further understanding of said objectives and the technological methods of the invention herein, brief description of the drawings is provided below followed by detailed description of the preferred embodiments.

### BRIEF DESCRIPTION OF THE DRAWINGS

FIG. 1 shows a schematic view of an application of a radio frequency identification system in a smart card according to prior art.
FIG. 2 shows a structural schematic view depicting a radio frequency identification within a smart card according to prior art.
FIG. 3 shows a flow diagram of a manufacturing method for conductive substrate using radiation curable conductive ink according to the present invention.
FIG. 4 shows another flow diagram of manufacturing method of conductive substrate using radiation curable conductive ink according to the present invention.

### DETAILED DESCRIPTION OF THE PREFERRED EMBODIMENTS

A radiation curable conductive ink of the present invention undergoes a chemical crosslinking reaction by irradiating conductive ink with radiation, wherein the conductive ink contains at least the following components:
(a) Conductive powder having a covering layer, wherein the weight of the silver content of the conductive powder before covering with the covering layer having less than 90% by weight of silver content, more than 30% by weight of copper or more than 30% by weight of aluminum;
(b) The covering layer covering surface of the conductive powder, wherein weight of silver content of the covering layer accounts for more than 30% of the weight of the covering layer, and the weight of the covering layer accounts for less than 80% of the total weight of the conductive powder and the covering layer;
(c) The conductive powder having the covering layer, wherein average size of conductive powder is less than 40 micro;
(d) A photosensitive binder having a viscosity less than 5,000 cps under temperature conditions at 25° and contains at least one reactive cyclized organic compound that can undergo polymerization, such as reactive cyclized monomer or reactive cyclized oligomer.

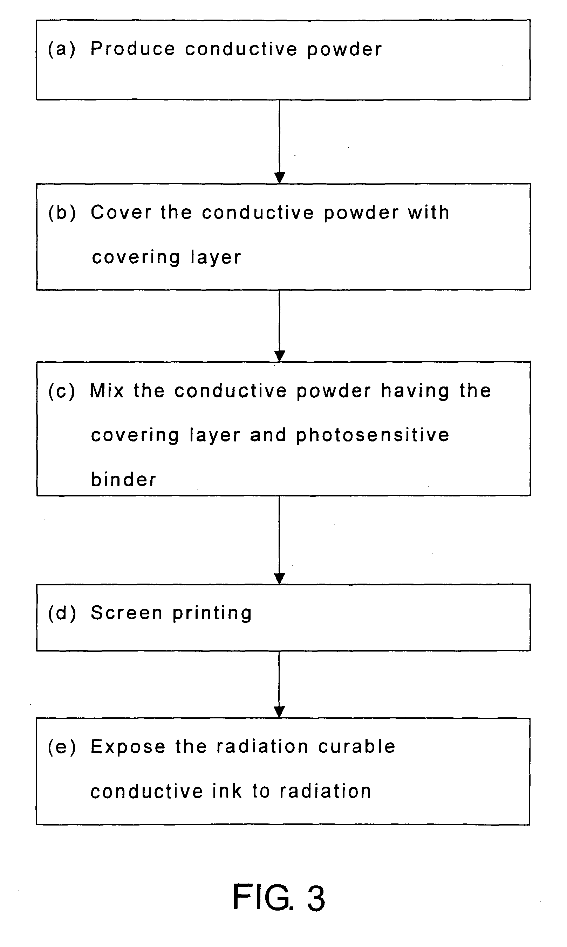

Referring to FIG. 3, which depicts a rapid manufacturing process for a conductive substrate material, wherein the radiation curable conductive ink of the present invention primarily comprises the conductive powder having the covering layer and the photosensitive binder. The manufacturing process adopted has the following steps:
(a) Apply the conductive powder;
(b) Cover the conductive powder with the covering layer, wherein weight of silver content of the covering layer accounts for more than 30% of the weight of the covering layer, and the weight of the covering layer accounts for less than 80% of the total weight of the conductive powder and the covering layer;
(c) Mix the conductive powder having the covering layer and the photosensitive binder, wherein the photosensitive binder has a viscosity of less than 5,000 cps at a temperature of 25°C, thereby forming the radiation curable conductive ink;
(d) Print the radiation curable conductive ink onto a surface of the substrate using a screen printing method;
(e) Expose the radiation curable conductive ink to radiation, thereby causing the radiation curable conductive ink to undergo a chemical crosslinking reaction, and the conductive substrate is formed therefrom.

The conductive material manufactured by the present invention using the aforementioned method has an application range including at least: radio frequency identification (RFID) antenna, printed-circuit boards, smart card inductive components, smart labels, printed electronics, anti-EMI (electromagnetic interference), and anti-electrostatic materials.

In addition, the aforementioned step (d) in FIG 3 uses screen printing to print the radiation curable conductive ink onto the substrate, and the form of the printed lines include at least reticular form, lattice form and honeycomb form, thereby enabling the radiation to irradiate within interstices of the aforementioned forms, which increases irradiating area and enhances curable efficiency, thus achieving a substantially greater thickness.

Furthermore, the radiation used in the aforementioned radiation curable conductive printing ink and manufacturing method for conductive substrate using conductive ink of the present invention is one or more than one of the following three examples of radiation:
(1) Ultraviolet ray;
(2) Visible light ray;
(3) Electron beam.

The conductive powder within the components of the aforementioned radiation curable conductive printing ink and manufacturing method for conductive substrate using conductive ink of the present invention contains silver, copper or aluminum, content of which is one or more than one of the following three embodiments:
(1) The weight of silver content of the conductive powder before covering with a covering layer accounts for less than 90% of the weight of the conductive powder without the covering layer;
(2) The weight of copper content of the conductive powder before covering with a covering layer accounts for more than 30% of the weight of the conductive powder without the covering layer;
(3) The weight of aluminum content of the conductive powder before covering with a covering layer accounts for more than 30% of the weight of the conductive powder without the covering layer.

The aforementioned conductive powder with covering layer, wherein average size of the conductive powder is less than 40 micro.

The conductive powder having the covering layer mixed with the photosensitive binder, wherein, the photosensitive binder contains at least one reactive cyclized organic compound that can undergo polymerization, such as reactive cyclized monomer or reactive cyclized oligomer, and in addition, the photosensitive binders contains at least one photoinitiator that is able to absorb visible light within a 390-800 mm wavelength range, wherein weight of the photoinitiator content accounts for less than 20% of the total weight of the radiation curable conductive ink. The photoinitiator can be TPO (diphenyl-(2.4.6-trimethylbenzoyl) phosphine oxide, CAS No. 75980 - 60 - 8), Ciba Irgacure-819 (Bis(2.4.6-rimethylbenzoyl)-phenylphosphineoxide), ITX (isopropyl thioxanthone, CAS No. 5495-84-1 and 83846-86-0), CPTX (1-Chloro-4-propoxythioxanthone 1-chloro-4-propoxythioxanthone 1-chloro-4-Hs propoxy-9s-thioxanthen-9-one. CAS No. 142770-42-1), EPD (ethyl 4-(dimethylamino) benzoate ethyl p-(dimethylamino) benzoate, CAS No.10287-53-3), and so on, increasing curable efficiency therewith.

In another embodiment of the radiation curable conductive ink of the present invention, a radiation curable conductive ink of the present invention undergoes a chemical crosslinking reaction by irradiating conductive ink with radiation, wherein the conductive ink contains at least the following components:
(a) Metallic conductive powder, wherein the average size of the of the conductive powder is less than 40 micro;
(b) A photosensitive binder having a viscosity less than 5,000 cps under temperature condition at 25°C and contains at least one reactive cyclized organic compound that can undergo polymerization, such as reactive cyclized monomer or reactive cyclized oligomer.

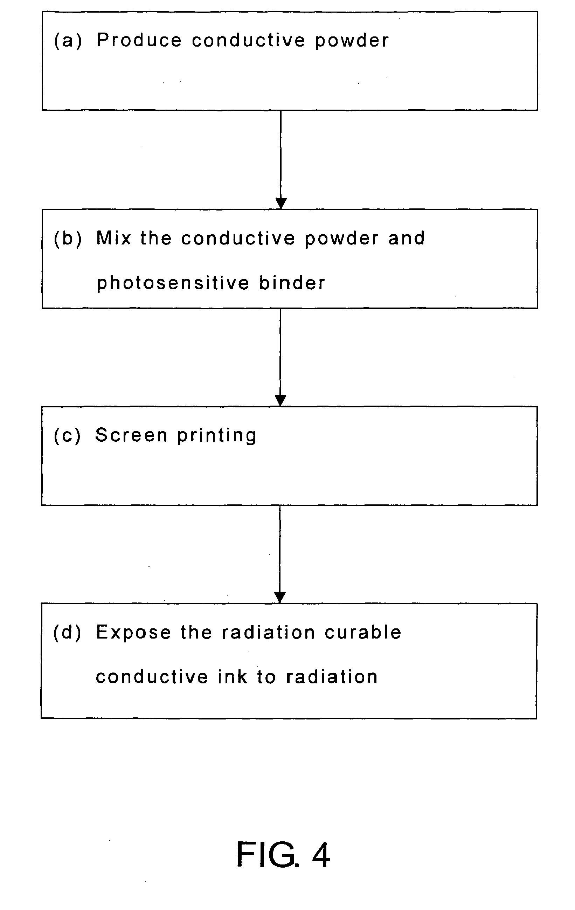

Referring to FIG. 4, which depicts a rapid manufacturing process for a conductive substrate material, wherein the radiation curable conductive ink of the present invention primarily comprises the conductive powder and the photosensitive binder. The manufacturing process adopted has the following steps:
(a) Apply the metallic conductive powder;
(b) Mix the conductive powder and the photosensitive binder, thereby forming the radiation curable conductive ink;
(c) Print the radiation curable conductive ink onto a surface of the substrate using a screen printing method;
(d) Expose the radiation curable conductive ink to radiation, thereby causing the radiation curable conductive ink to undergo a chemical crosslinking reaction, and the conductive substrate is formed therefrom.

The conductive material manufactured by the present invention using the aforementioned method has an application range including at least: radio frequency identification (RFID) antenna, printed-circuit boards, smart card inductive components, smart labels, printed electronics, anti-EMI (electromagnetic interference), and anti-electrostatic materials.

In addition, the aforementioned step (c) in FIG 4 uses screen printing to print the radiation curable conductive ink onto the substrate, and the form of the printed lines include at least reticular form, lattice form and honeycomb form, thereby enabling the radiation to irradiate within interstices of the aforementioned forms, which increases irradiating area and enhances curable efficiency, thus achieving a substantially greater thickness.

Furthermore, the radiation used in the aforementioned radiation curable conductive printing ink and manufacturing method for conductive substrate using conductive ink of the present invention is one or more than one of the following three examples of radiation:
(1) Ultraviolet ray;
(2) Visible light ray;
(3) Electron beam.

The conductive powder mixed with the photosensitive binder contains at least one photoinitiator that is able to absorb visible light within a 390-800 mm wavelength range, wherein weight of the photoinitiator content accounts for less than 20% of the total weight of the radiation curable conductive ink. The photoinitiator can be TPO (diphenyl-(2.4.6-trimethylbenzoyl) phosphine oxide, CAS No. 75980 - 60 - 8), Ciba Irgacure-819 (Bis(2.4.6-rimethylbenzoyl)-phenylphosphineoxide), ITX (isopropyl thioxanthone, CAS No. 5495-84-1 and 83846-86-0), CPTX (1-Chloro-4-propoxythioxanthone 1-chloro-4-propoxythioxanthone 1-chloro-4-Hs propoxy-9s-thioxanthen-9-one. CAS No. 142770-42-1), EPD (ethyl 4-(dimethylamino) benzoate ethyl p-(dimethylamino) benzoate, CAS No. 10287-53-3), and so on, increasing curable efficiency therewith.

The components of the aforementioned radiation curable conductive printing inks and manufacturing methods for conductive material using conductive inks of the present invention can further contain of volatile organic compound, anti-settling agent (anti-precipatant) less than 10% of the total weight or contain an organic dispersant less than 15% of the total weight. The anti-settling agent is a silicate and the organic dispersant is surfactant, therewith increasing dispersibility of the conductive powder and preventing or retarding rate of precipitation, thereby providing the conductive printing ink after undergoing radiation curable with superior electrical conductivity and electrical conducting stability.

The components of the aforementioned radiation curable conductive printing inks and manufacturing methods for conductive material using conductive inks of the present invention further contain at least one coupling agent, weight content of which accounts for less than 25% of the total weight of the conductive ink, therewith enhancing material properties of the conductive ink after undergoing radiation crooslinking, thereby improving the electrical conducting stability and bonding strength with inorganic materials (such as conductive powder, glass, ceramic, and so on).

The components of the aforementioned radiation curable conductive printing inks and manufacturing methods for conductive material using conductive inks of the present invention further contain an antioxidant or a metal corrosion inhibitor, weight content of which accounts for less than 5% of the total weight, therewith further improving the heat resisting property, durability and electrical conducting stability of the conductive ink, particularly when placed in environments of high temperature and high humidity or corrosive environments.

The components of the aforementioned radiation curable conductive printing inks and manufacturing methods for conductive material using conductive inks of the present invention further contain 15 ppm-5000ppm of a polymerization inhibitor. The polymerization inhibitor can be either MEHQ (monomethyl ether hydroquinone) or HQ (hydroquinone), therewith further improving storage stability.

It is of course to be understood that the embodiments described herein are merely illustrative of the principles of the invention and that a wide variety of modifications thereto may be effected by persons skilled in the art without departing from the spirit and scope of the invention as set forth in the following claims.

## Claims

1. A radiation curable conductive ink having a chemical crosslinking reaction is achieved by irradiating with radiation, wherein the conductive ink contains at least the following components:
(a) conductive powder having a covering layer, wherein the weight of the silver content of the conductive powder before covering with the covering layer accounts for less than 90% of the weight of the conductive powder before covering with the covering layer;
(b) the covering layer covering surface of the conductive powder, wherein the weight of silver content of the covering layer accounts for more than 30% of the weight of the covering layer, and the weight of the covering layer accounts for less than 80% of the total weight of the conductive powder and the covering layer;
(c) the conductive powder having the covering layer, wherein average size of the conductive powder is less than 40 micro;
(d) a photosensitive binder having a viscosity less than 5,000 cps under temperature condition at 25°C and contains at least one reactive cyclized organic compound that can undergo polymerization.

2. A radiation curable conductive ink having a chemical crosslinking reaction is achieved by irradiating with radiation, wherein the conductive ink contains at least the following components:
(a) conductive powder having a covering layer, wherein the weight of copper content of the conductive powder before covering with the covering layer accounts for more than 30% of the weight of the conductive powder before covering with the covering layer;
(b) the covering layer covering surface of the conductive powder, wherein the weight of silver content of the coving layer accounts for more than 30% of the weight of the covering layer, and the weight of the covering layer accounts for less than 80% of the total weight of the conductive powder and the covering layer;
(c) the conductive powder having the covering layer, wherein average size of the conductive powder is less than 40 micro;
(d) the photosensitive binder having a viscosity less than 5,000 cps under temperature condition at 25°C and contains at least one reactive cyclized organic compound that can undergo polymerization.

3. A radiation curable conductive ink having a chemical crosslinking reaction is achieved by irradiating with radiation, wherein the conductive ink contains at least the following components:
(a) conductive powder having a covering layer, wherein the weight of the aluminum content of the conductive powder before covering with the covering layer accounts for more than 30% of the weight of the conductive powder before covering with the covering layer;
(b) the covering layer covering surface of the conductive powder, wherein the weight of silver content of the covering layer accounts for more than 30% of the weight of the covering layer, and the weight of the covering layer accounts for less than 80% of the total weight of the conductive powder and the covering layer;
(c) the conductive powder having the covering layer, wherein average size of the conductive powder is less than 40 micro;
(d) the photosensitive binder having a viscosity less than 5,000 cps under temperature condition at 25°C and contains at least one reactive cyclized organic compound that can undergo polymerization.

4. A radiation curable conductive ink having a chemical crosslinking reaction is achieved by irradiating with radiation, wherein the conductive ink contains at least the following components:
(a) metallic conductive powder, wherein the average size of the metallic conductive powder is less than 40 micro;
(b) a photosensitive binder having a viscosity less than 5,000 cps under temperature condition at 25°C and contains at least one reactive cyclized organic compound that can undergo polymerization.

5. A manufacturing method for conductive substrate using the radiation curable ink, comprising the following steps:
(a) applying the conductive powder, wherein the weight of silver content of the conductive powder accounts for less than 90% of the weight of the conductive powder;
(b) covering the conductive powder with the covering layer, wherein the weight of silver content of the covering layer accounts for more than 30% of the weight of the covering layer, and the weight of the covering layer accounts for less than 80% of the total weight of the conductive powder and the covering layer, and the conductive powder having the covering layer, wherein average size of the conductive powder is less than 40 micro;
(c) mixing the conductive powder having the covering layer and the photosensitive binder, wherein the photosensitive binder has a viscosity of less than 5,000 cps at a temperature of 25°C and contains at least one reactive cyclized organic compound that can undergo polymerization, thereby forming the radiation curable conductive ink;
(d) printing the radiation curable conductive ink onto a surface of a substrate using a screen printing method;
(e) exposing the radiation curable conductive ink to radiation, thereby causing the radiation curable conductive ink to undergo a chemical crosslinking reaction, and the conductive substrate is formed therefrom.

6. A manufacturing method for conductive substrate using the radiation curable ink, comprising the following steps:
(a) applying the conductive powder, wherein the weight of copper content of the conductive powder accounts for more than 30% of the weight of the conductive powder;
(b) covering the conductive powder with the covering layer, wherein the weight of silver content of the covering layer accounts for more than 30% of the weight of the covering layer, and the weight of the covering layer accounts for less than 80% of the total weight of the conductive powder and the covering layer, and the conductive powder having the covering layer, wherein average size of the conductive powder is less than 40 micro;
(c) mixing the conductive powder having the covering layer and the photosensitive binder, wherein the photosensitive binder has a viscosity of less than 5,000 cps under temperature condition at 25°C and contains at least one reactive cyclized organic compound that can undergo polymerization, thereby forming the radiation curable conductive ink;
(d) printing the radiation curable conductive ink onto surface of the substrate using a screen printing method;
(e) exposing the radiation curable conductive ink to radiation, thereby causing the radiation curable conductive ink to undergo a chemical crosslinking reaction, and the conductive substrate is formed therefrom.

7. A manufacturing method for conductive substrate using the radiation curable ink, comprising the following steps:
(a) applying the conductive powder, wherein the weight of aluminum content of the conductive powder accounts for more than 30% of the weight of the conductive powder;
(b) covering the conductive powder with the covering layer, wherein the weight of silver content of the covering layer accounts for more than 30% of the weight of the covering layer, and the weight of the covering layer accounts for less than 80% of the total weight of the conductive powder and the covering layer, and the conductive powder having the covering layer, wherein average size of the conductive powder is less than 40 micro;
(c) mixing the conductive powder having the covering layer and the photosensitive binder, wherein the photosensitive binder has a viscosity of less than 5,000 cps at a temperature of 25°C and contains at least one reactive cyclized organic compound that can undergo polymerization, thereby forming the radiation curable conductive ink;
(d) printing the radiation curable conductive ink onto surface of the substrate using a screen printing method;
(e) exposing the radiation curable conductive ink to radiation, thereby causing the radiation curable conductive ink to undergo a chemical crosslinking reaction, and the conductive substrate is formed therefrom.

8. A manufacturing method for conductive substrate using the radiation curable ink, comprising the following steps:
(a) applying the metallic conductive powder, wherein the average size of the conductive powder is less than 40 micro;
(b) mixing the conductive powder and the photosensitive binder, wherein the photosensitive binder has a viscosity of less than 5,000 cps at a temperature of 25°C and contains at least one reactive cyclized monomer or reactive cyclized oligomer, thereby forming the radiation curable conductive ink;
(c) printing the radiation curable conductive ink onto surface of the substrate using a screen printing method;
(d) exposing the radiation curable conductive ink to radiation, thereby causing the radiation curable conductive ink to undergo a chemical crosslinking reaction, and the conductive substrate is formed therefrom.

9. The radiation curable conductive ink according to claim 1, wherein the radiation used for irradiating is ultraviolet ray, visible light ray or electron bean.

10. The radiation curable conductive ink according to claim 2, wherein the radiation used for irradiating is ultraviolet ray, visible light ray or electron bean.

11. The radiation curable conductive ink according to claim 3, wherein the radiation used for irradiating is ultraviolet ray, visible light ray or electron bean.

12. The radiation curable conductive ink according to claim 4, wherein the radiation used for irradiating is ultraviolet ray, visible light ray or electron bean.

13. The radiation curable conductive ink according to claim 1, wherein components further contain at least one coupling agent, weight content of which accounts for less than 10% of the total weight of the conductive ink.

14. The radiation curable conductive ink according to claim 2, wherein components further contain at least one coupling agent, weight content of which accounts for less than 10% of the total weight of the conductive ink.

15. The radiation curable conductive ink according to claim 3, wherein components further contain at least one coupling agent, weight content of which accounts for less than 10% of the total weight of the conductive ink.

16. The radiation curable conductive ink according to claim 4, wherein the conductive ink further contains at least one coupling agent, weight content of which accounts for less than 10% of the total weight of the conductive ink.
